# EUROPÄISCHE PATENTANMELDUNG

(11) **EP 3 595 126 A1**
(43) Veröffentlichungstag der Anmeldung: **15.01.2020**
(21) Anmeldenummer: 19182831.8
(22) Anmeldetag: 27.06.2019
(51) Int. Cl.: H02J 7/00

(54) **VERFAHREN ZUM LADEN EINER BATTERIE UND STEUEREINHEIT**

(30) Priorität: 09.07.2018 DE 102018211265
(71) Anmelder: Volkswagen AG, 38440 Wolfsburg (DE)
(72) Erfinder: Aust, Stefan, 38108 Braunschweig (DE); Calles, Simon, 67454 Haßloch (DE)
(74) Vertreter: Patentanwälte Bressel und Partner mbB

(57) **Zusammenfassung**

Die Erfindung betrifft ein Verfahren zum Laden einer Batterie (2) mittels einer elektrischen Energiequelle (3), wobei der elektrischen Energiequelle (3) eine Steuereinheit (5) zugeordnet ist, die die Energiequelle (3) oder einen Pulsgenerator (4) steuert, wobei die Steuereinheit (5) die Energiequelle (3) oder den Pulsgenerator (4) derart ansteuert, dass ein Ladepuls (LP) erzeugt wird, wobei der Ladepuls (LP) mindestens einen Puls (P) und eine Pulspause (PP) aufweist, wobei die Pulspause (PP) einen Ladestrom größer Null aufweist, wobei das Verfahren solange fortgesetzt wird, bis eine vorgegebene Abbruchbedingung erfüllt ist, sowie eine zugehörige Steuereinheit (5).

## Beschreibung

Die Erfindung betrifft ein Verfahren zum Laden einer Batterie und eine Steuereinheit.

Derzeit werden Batterien (z.B. Li-Ionen) mit immer höheren Strömen geladen, um die Ladezeit verringern zu können. Dabei wird bis zum Erreichen der Ladeschlussspannung mit einem konstanten Strom geladen (CC-Phase) und anschließend die Spannung konstant gehalten bei gleichzeitiger Reduktion des Stromes (CV-Phase). Diese CV-Phase benötigt durch geringe Ladeströme lange Ladezeiten. Ein solches Verfahren wird auch als CC/CV-Verfahren (const current/constant voltage) bezeichnet und wird in der DE 10 2010 051 016 A1 als Stand der Technik beschrieben.Des Weiteren sind Verfahren zum Laden bekannt, die Strom in Form von Ladepulsen verwenden. Aus der US 2013/0026976 A1 ist ein Verfahren bekannt, bei dem ein Ladepuls einen positiven Puls aufweist sowie eine Pulspause und einen Entladepuls, wobei bei der Pulspause der Strom größer oder gleich Null sein kann. Abhängig von der Spannung der Batterie wird die Länge des Pulses reduziert. Dabei ist auch vorgesehen, dass die Höhe des Entladepulses reduziert wird. Übersteigt dann die Spannung an der Batterie einen Schwellwert, so wird das Verfahren beendet. Dabei wird das Zeitsegment eines Ladepulses zum Ende hin reduziert. In einer alternativen Ausführungsform wird nur die Pulsauszeit in dem Maße verlängert, wie die Pulszeit verkürzt wird. Schließlich wird noch eine Ausführungsform offenbart, bei der der Entladepuls durch zwei Pulspausen eingerahmt ist. Das letztere Verfahren ist auch aus der US 5,481,174 A bekannt. Die Entladepulse dienen dabei zu einer kurzzeitigen Umkehr des Ionenflusses, was die Einlagerung der Ionen insgesamt begünstigt.

Die Pulsladeverfahren haben das Potential, die Ladezeiten signifikant zu verkürzen. In der Regel kann die Batterie signifikant mehr maximalen Spitzenstrom (peak current) über einen kurzen Zeitraum aufnehmen als einem maximalen Dauerstrom (continuous current) über einen langen Zeitraum. Der Grund dafür ist primär, dass aufgrund der pulsartigen Ansteuerung RC-Glieder der Batterie nicht vollständig geladen werden, was im Betrieb mit konstantem Ladestrom zu erhöhten Innenwiderständen führt, was wiederum den Ladestrom begrenzt und zu erhöhter Alterung führt.

Der Erfindung liegt das technische Problem zugrunde, ein Verfahren zum Laden einer Batterie weiter zu verbessern sowie eine hierfür geeignete Steuereinheit zu schaffen.

Die Lösung des technischen Problems ergibt sich durch ein Verfahren mit den Merkmalen des Anspruchs 1 sowie eine Steuereinheit mit den Merkmalen des Anspruchs 7. Weitere vorteilhafte Ausgestaltungen der Erfindung ergeben sich aus den Unteransprüchen.

Dabei erfolgt das Laden einer Batterie mittels einer elektrischen Energiequelle, wobei der elektrischen Energiequelle eine Steuereinheit zugeordnet ist, die die Energiequelle oder einen Pulsgenerator steuert, wobei die Steuereinheit die Energiequelle oder den Pulsgenerator derart ansteuert, dass ein Ladepuls erzeugt wird, wobei der Ladepuls mindestens einen Puls und eine Pulspause aufweist, wobei die Pulspause einen Ladestrom größer Null aufweist, wobei das Verfahren solange fortgesetzt wird, bis eine vorgegebene Abbruchbedingung erreicht ist. Erfindungsgemäß wird auf Entladepulse verzichtet und bewusst auch in den Pulspausen ein Haltestrom eingeprägt. Hierdurch wird verhindert, dass verschiedene Ladesäulen als Energiequelle fehlerhaft auf einen abgebrochenen Ladevorgang erkennen und die Energiezufuhr einstellen. Der Haltestrom liegt dabei beispielsweise bei 5 A. Vorzugsweise liegt dabei der Haltestrom bei ca. 2 % bis 10 % des maximalen Stromes des Pulses.

In einer Ausführungsform ermittelt die Steuereinheit anhand von Batterieparametern wie beispielsweise Temperatur, SOC und Spannung, ob ein Lademodus mit konstantem oder ein Lademodus mit gepulstem Ladestrom zu den gegebenen Batterieparametern schneller ist, wobei dann die Steuereinheit auf den entsprechenden Lademodus umschaltet. Beispielsweise bei relativ hohen Temperaturen wie beispielsweise 30° C kann ein Laden mit konstantem Ladestrom schneller sein, wohingegen bei niedrigen Temperaturen ein Pulsladen schneller sein kann. Ebenso kann ein Pulsladen schneller sein, wenn der SOC-Wert bereits relativ hoch ist. Das optimale Verfahren wird dabei in Echtzeit ermittelt und eingestellt.

In einer weiteren Ausführungsform sind die Gradienten der Anstiege und Abstiege der Pulse betragsmäßig begrenzt, beispielsweise auf 20 A/s. Auch dies sichert einen reibungslosen Betrieb an verschiedenen Ladesäulen.

In einer weiteren Ausführungsform liegt das Tastverhältnis von Puls zu Pulspause zwischen 50:50 bis 90:10, vorzugsweise bei 80:20.

In einer weiteren Ausführungsform liegt die Länge eines Pulses zwischen 10 s und 60 s, vorzugsweise bei 30 s.

In einer weiteren Ausführungsform sind in der Steuereinheit SOH-abhängige Kennfelder abgelegt, anhand derer der maximal zulässige Ladestrom der Pulse ermittelt wird. Insbesondere zu Beginn (BoL Begin of Life) haben Batteriezellen einen geringen Innenwiderstand, sodass in diesen Phasen mit höheren Strömen geladen werden kann.

In einer weiteren Ausführungsform ist die vorgegebene Abbruchbedingung ein Grenzwert für den SOC-Wert der Batterie. Der Grenzwert kann dabei 80 %, vorzugsweise 90 % und weiter vorzugsweise 95 % oder 100 % betragen. Eine weitere Abbruchbedingung kann beispielsweise eine Spannung sein.

Die Steuereinheit zum Steuern einer elektrischen Energiequelle oder eines Pulsgenerators zum Erzeugen von Ladepulsen zum Laden einer Batterie ist derart ausgebildet, die Energiequelle oder den Pulsgenerator derart anzusteuern, dass ein Ladepuls erzeugt wird, wobei der Ladepuls mindestens einen Puls und eine Pulspause aufweist, wobei die Pulspause einen Ladestrom größer Null aufweist, wobei die Steuereinheit weiter derart ausgebildet ist, die Ladepulse solange zu erzeugen, bis eine vorgegebene Abbruchbedingung erreicht ist.

Hinsichtlich der möglichen weiteren Ausgestaltung der Steuereinheit wird auf die vorangegangenen Ausführungen zum Verfahren Bezug genommen.

Die Erfindung wird nachfolgend anhand bevorzugter Ausführungsbeispiele näher erläutert. Die Figuren zeigen:
- Fig. 1: ein schematisches Blockschaltbild einer Vorrichtung zum Laden einer Batterie,
- Fig. 2: einen beispielhaften Ladepuls und
- Fig. 3: eine beispielhafte Ladepulsfolge.

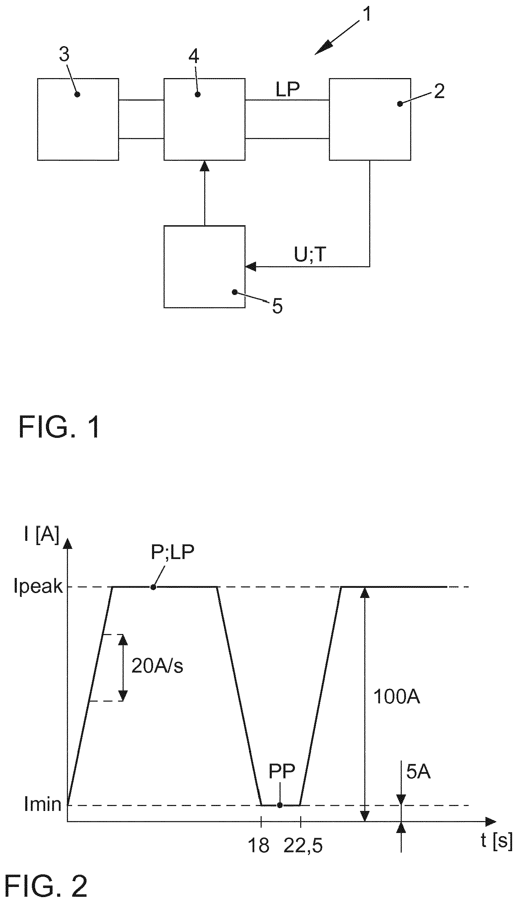

In der Fig. 1 ist schematisch ein Blockschaltbild einer Vorrichtung 1 zum Laden einer Batterie 2 dargestellt. Die Vorrichtung 1 weist eine elektrische Energiequelle 3, einen Pulsgenerator 4 sowie eine Steuereinheit 5 auf. Die elektrische Energiequelle 3 kann dabei eine Gleich- oder Wechselspannungsquelle sein, wobei der Pulsgenerator 4 dazu ausgebildet ist, die elektrische Energie der Energiequelle 3 in Ladepulse LP zu wandeln. Die Steuereinheit 5 erhält Daten wie beispielsweise Spannung und Temperatur von der Batterie 2. Zusätzlich sind in der Steuereinheit 5 Kennlinien von Strom I, Spannung U und Temperatur T abgelegt, aus denen sich beispielsweise der maximal zulässige Strom I bei einer bestimmten Temperatur und Spannung der Batterie 2 ergibt.

Die Steuereinheit 5 ist weiter derart ausgebildet, aus den Batterieparametern sowie dem Ladestrom I den SOC-Wert der Batterie 2 zu ermitteln. Des Weiteren ist die Steuereinheit 5 derart ausgebildet zu ermitteln, ob bei den gegebenen Batterieparametern ein Laden mit konstantem Strom oder gepulstem Strom schneller ist. Schließlich sind noch SOH-abhängige Kennfelder von Batterieparametern abgelegt (SOH state of health). Dabei sei noch angemerkt, dass der Pulsgenerator 4 auch in die Energiequelle 3 integriert sein kann.

In der Fig. 2 ist ein beispielhafter Ladepuls LP dargestellt, der sich aus einem trapezförmigen Puls P und einer Pulspause PP zusammensetzt. Der Gradient des Pulses P ist dabei auf 20 A/s begrenzt, wobei der maximale Spitzenstrom Iₚₑₐₖ des Pulses P beispielsweise 100 A beträgt. In der Pulspause PP beträgt die Stromstärke Iₘᵢₙ 5 A. Die Länge des Pulses P beträgt beispielsweise 18 s und die Pulspause PP hat beispielsweise eine Länge von 4,5 s, sodass insgesamt eine Ladepulsdauer von 22,5 s eingestellt ist, wobei das Tastverhältnis von Puls P zu Pulspause PP 80:20 beträgt.

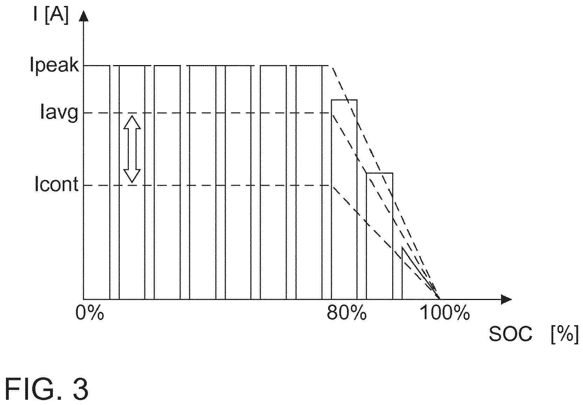

In der Fig. 3 ist nun schematisch eine Ladepulsfolge über dem Ladezustand SOC dargestellt. Dabei ist die gemittelte Stromstärke I_{avg} der Ladepulse LP gestrichelt eingezeichnet, sowie eine Stromstärke I_{cont'} für ein Laden mit einem konstanten Strom. Die Differenz zwischen der gemittelten I_{avg} sowie der Stromstärke I_{cont} stellt dabei ein Maß für die erhöhte Ladeleistung dar. Bei höheren Ladezuständen um die 80 % muss auch beim Pulsladen die Stromstärke Iₚₑₐₖ reduziert werden, um nicht die zulässige Spannung der Batteriezellen zu überschreiten. Allerdings ist die Ladeleistung immer noch höher als beim Laden mit einem konstanten Strom I_{cont}.

## Patentansprüche

1. Verfahren zum Laden einer Batterie (2) mittels einer elektrischen Energiequelle (3), wobei der elektrischen Energiequelle (3) eine Steuereinheit (5) zugeordnet ist, die die Energiequelle (3) oder einen Pulsgenerator (4) steuert, wobei die Steuereinheit (5) die Energiequelle (3) oder den Pulsgenerator (4) derart ansteuert, dass ein Ladepuls (LP) erzeugt wird, wobei der Ladepuls (LP) mindestens einen Puls (P) und eine Pulspause (PP) aufweist, wobei die Pulspause (PP) einen Ladestrom größer Null aufweist, wobei das Verfahren solange fortgesetzt wird, bis eine vorgegebene Abbruchbedingung erfüllt ist.

2. Verfahren nach Anspruch 1, **dadurch gekennzeichnet, dass** die Steuereinheit (5) anhand von Batterieparametern ermittelt, ob ein Lademodus mit einem konstanten oder ein Lademodus mit einem gepulsten Ladestrom zu den gegebenen Batterieparametern schneller ist, wobei dann die Steuereinheit (5) auf den entsprechenden schnelleren Lademodus umschaltet.

3. Verfahren nach einem der vorangegangenen Ansprüche, **dadurch gekennzeichnet, dass** die Gradienten der Anstiege und Abstiege der Pulse (P) betragsmäßig begrenzt sind.

4. Verfahren nach einem der vorangegangenen Ansprüche, **dadurch gekennzeichnet, dass** das Tastverhältnis von Puls (P) zu Pulspause (PP) zwischen 50:50 bis 90:10 liegt.

5. Verfahren nach einem der vorangegangenen Ansprüche, **dadurch gekennzeichnet, dass** die Länge eines Pulses zwischen 10 s und 60 s liegt.

6. Verfahren nach einem der vorangegangenen Ansprüche, **dadurch gekennzeichnet, dass** in der Steuereinheit (5) SOH-abhängige Kennfelder abgelegt sind, anhand derer der maximal zulässige Ladestrom (Iₚₑₐₖ) der Pulse (P) ermittelt wird.

7. Verfahren nach einem der vorangegangenen Ansprüche, **dadurch gekennzeichnet, dass** die vorgegebene Abbruchbedingung ein Grenzwert für den SOC-Wert der Batterie (2) ist.

8. Steuereinheit (5) zum Steuern einer elektrischen Energiequelle (3) oder eines Pulsgenerators (4) zum Erzeugen von Ladepulsen (LP) zum Laden einer Batterie (2), wobei die Steuereinheit (5) derart ausgebildet ist, die Energiequelle (3) oder den Pulsgenerator (4) derart anzusteuern, dass ein Ladepuls (LP) erzeugt wird, wobei der Ladepuls (LP) mindestens einen Puls (P) und eine Pulspause (PP) aufweist, wobei die Pulspause (PP) einen Ladestrom größer Null aufweist, wobei die Steuereinheit (5) weiter derart ausgebildet ist, die Ladepulse (LP) solange zu erzeugen, bis eine vorgegebene Abbruchbedingung erreicht ist.

9. Steuereinheit nach Anspruch 8, **dadurch gekennzeichnet, dass** die Steuereinheit (5) derart ausgebildet ist, anhand von Batterieparametern zu ermitteln, ob ein konstanter oder ein gepulster Ladestrom zu den gegebenen Batterieparametern schneller ist, wobei dann die Steuereinheit (5) auf den entsprechenden Lademodus umschaltet.

10. Steuereinheit nach Anspruch 8 oder 9, **dadurch gekennzeichnet, dass** die Steuereinheit (5) derart ausgebildet ist, dass das Tastverhältnis von Puls (P) zu Pulspause (PP) zwischen 50:50 bis 90:10 liegt.

11. Steuereinheit nach einem der Ansprüche 8 bis 10, **dadurch gekennzeichnet, dass** in der Steuereinheit (5) SOH-abhängige Kennfelder abgelegt sind, anhand derer der maximal zulässige Ladestrom (Iₚₑₐₖ) der Pulse (P) ermittelt wird.
